# EUROPÄISCHE PATENTSCHRIFT

(11) **EP 2 206 149 B1**
(45) Veröffentlichungstag und Bekanntmachung des Hinweises auf die Patenterteilung: **15.11.2017**
(21) Anmeldenummer: 08804103.3
(22) Anmeldetag: 12.09.2008
(51) Int. Cl.: H01L 23/66, H01L 25/00, H01Q 23/00, H01L 21/60

(54) **HF-CHIPMODUL, HF-BAUGRUPPE UND VERFAHREN ZUR HERSTELLUNG EINER HF-BAUGRUPPE**
HF CHIP MODULE, HF ASSEMBLY AND METHOD FOR PRODUCING AN HF ASSEMBLY
MODULE DE PUCE HF, ENSEMBLE HF ET PROCÉDÉ DE PRODUCTION D'ENSEMBLE HF

(30) Priorität: 30.10.2007 DE 102007051875
(43) Veröffentlichungstag der Anmeldung: 14.07.2010
(73) Patentinhaber: Robert Bosch GmbH, 70442 Stuttgart (DE)
(72) Erfinder: WOSTRADOWSKI, Uwe, 71272 Renningen (DE); BRUEGGEMANN, Oliver, 75248 Oelbronn-Duerrn (DE); WEIKERT, Lars, 70180 Stuttgart (DE); HANSEN, Thomas, 31139 Hildesheim (DE); SCHMIDT, Ewald, 71634 Ludwigsburg (DE)
(86) Internationale Anmeldenummer: PCT/EP2008/062138
(87) Internationale Veröffentlichungsnummer: WO 2009/056387

(56) Entgegenhaltungen:
- WO-A1-2006/112447
- DE-A1- 10 355 796
- DE-A1-102004 003 342
- DE-A1-102006 009 012
- US-A- 5 676 301
- ERICSSON INC: "Means for aligning or locating printed circuit boards using stress relief slots" RESEARCH DISCLOSURE, MASON PUBLICATIONS, HAMPSHIRE, GB, Bd. 423, Nr. 64, 1. Juli 1999 (1999-07-01), XP007124598 ISSN: 0374-4353

## Beschreibung

Die vorliegende Erfindung betrifft ein HF-Chipmodul mit einem streifenförmigen flächigen Substrat, mindestens einem HF-Chip und mindestens einer Antenneneinrichtung, einer HF-Baugruppe sowie ein Verfahren zur Herstellung einer HF-Baugruppe.

Die US 5, 676,301 A offenbart ein Chipmodul mit einem quadratischen flächigen Substrat mit einer vorderseitigen Oberfläche und einer rückseitigen Oberfläche, mindestens einem Chip mit einer Vorderseite und einer Rückseite, der über seine Vorderseite auf die vorderseitige Oberfläche des Substrats angebracht ist, wobei die Vorderseite des Chips Kontaktflächen aufweist, die mit auf der vorderseitigen Oberfläche des Substrats vorgesehenen Leiterbahn verbunden sind, wobei die Leiterbahnen zu entsprechenden Anschlussbereichen verlaufen, welche vom Chip versetzt zumindest auf der vorderseitigen Oberfläche des Substrats vorgesehen sind.

Die DE 103 55 796 A1 offenbart eine integrierte Schaltung zur Abstands- und/oder Geschwindigkeitsmessung von Objekten, welche einen HF-Chip aufweist, auf dessen Vorderseite eine Antenneneinrichtung angeordnet ist.

Eine Antenneneinrichtung auf der Vorderseite eines HF-Chips anzuordnen ist auch aus der DE 10 2006 009 012 bekannt.

Die DE 10 2004 003 342 A1 offenbart, einen Antennenanschluss auf der Vorderseite eines HF-Chips anzuordnen, der mit einer auf der rückseitigen Oberfläche eines Substrats vorgesehenen Antenneneinrichtung verbunden ist.

Die WO 2006/112447 A1 offenbart ein HF-Chipmodul mit einem streifenförmigen, flächigen Substrat mit einer vorderseitigen Oberfläche und einer rückseitigen Oberfläche mindestens einem HF-Chip mit einer Vorderseite und einer Rückseite, der über seine Vorderseite auf vorderseitige Oberfläche des Substrates angebracht ist; wobei die Vorderseite desHF-Chips Kontaktflächen aufweist, die mit auf der vorderseitigen Oberfläche des Substrates vorgesehenen Leiterbahnen verbunden sind; wobei die Leiterbahnen zu entsprechenden Anschlussbereichen verlaufen, welche vom HF-Chip in Längsreichtung zu Schmalsseite des Substrates versetzt zumindes auf der vorderseitigen Oberfläche des Substrates vorgesehen sind; und welche zum Bilden elektrischer Verbindungendes HF-Chipmoduls mit einer Leiterplatteneinrichtung einer HF-Baugruppe eingerichtet sind.

Radarsensoren werden zur Abstands- und/oder Geschwindigkeitsmessung von Objekten verwendet. Insbesondere werden durch Radarsensoren Umgebungen, d.h. Geschwindigkeiten und Distanzen mehrerer Objekte simultan erfasst. Ein mehrstrahliges Kraftfahrzeugradarsystem ist beispielsweise aus DE 196 48 203 bekannt. Des Weiteren sind ein Verfahren und eine Vorrichtung zur Erfassung und Auswertung von Objekten im Umgebungsbereich eines Fahrzeugs aus DE 199 63 005 bekannt.

Kostengünstige, qualitativ hochwertige und platzsparende Radarsensoren werden als integrierte Halbleiterschaltungen nach DE 103 55 796 A1 als HF-Chips aufgebaut. Weiterhin ist die Gruppierung von HF-Chips in Moduleinheiten nach DE 10 2006 009 012 A1 bekannt. Außerdem sind Radarsensoren, die intern auf HF-Substraten Verteilernetzwerke zu Abstrahlelementen, d.h. eine oder mehrere Antenneneinrichtungen aufweisen, bilden, ebenfalls bekannt. Außerdem existieren Lösungen für Radarsensoren mit verschiedenen Aufgabenstellungen, die jeweils individuell entwickelte HF-Chips und darauf integrierten Antenneneinrichtungen aufweisen.

Der Nachteil der bekannten Ausführungen von Radarsensoren besteht darin, dass sie für die jeweilige vorgesehene Anwendung individuell konzipiert und hergestellt werden müssen und daher einen erheblichen Aufwand Ressourcen erfordern. Beispielsweise werden verschiedene Radarsensoren für Nahbereich bis ca. 10 m, Mittelbereich von ca. 10 - 60 m oder Fernbereich 150 m hergestellt.

Es besteht daher ein Interesse daran, Radarsensoren verschiedener Anwendungsgebiete als HF-Baugruppe mit unterschiedlicher Anzahl identischer HF-Chipmodule zu produzieren, die in hoher Stückzahl kostengünstig hergestellt werden können.

### OFFENBARUNG DER ERFINDUNG

Kern der Erfindung ist es, dass verschiedene Radarsensoren, wie beispielsweise für Nah- (SSR, Short-Range-Radar), Mittel- (MRR, Mid-Range-Radar) und Fernbereich (LRR, Long-Range-Radar), in unterschiedlichen HF-Baugruppen unter Verwendung identischer HF-Chipmodule identischer oder im Wesentlichen gleicher Herstellungsform aufgebaut werden können. Auf den HF-Chipmodulen ist mindestens ein HF-Chip mit mindestens einer integrierten HF-Antennenanlage auf einem streifenförmigen flächigen Substrat montiert. Alternativ können Antennenanlagen auch auf dem Substrat der HF-Chipmodule angebracht sein.

Durch die Verwendung identischer HF-Chipmodule für verschiedene HF-Baugruppen wird eine kostengünstige und hohe Produktionsstückzahl und eine Qualitätssteigerung erreicht. Diese Vorteile ergeben sich nicht nur durch die erhöhte Produktionsstückzahl der Einzelteile, sondern zum einen auch durch die reduzierte Entwicklungszeit, gegeben durch die mit dem gleichen HF-System verbundenen identischen Auswerte- und Softwareverfahren, und zum zweiten auch bei der Gerätemontage mit dem Synergiegewinn durch eine gemeinsame Fertigungslinie für verschiedene HF-Baugruppen.

Die erfindungsgemäßen HF-Chipmodule gemäß Anspruch 1 weisen daher den Vorteil auf, dass sie in HF-Baugruppen im Wesentlichen parallel und nebeneinander mit einem Abstand der Mitten der HF-Antenneneinrichtungen von einem Viertel der effektiven Wellenlänge, die sich aus der HF-Frequenz des HF-Chips bestimmt, angeordnet werden können. Diese Eigenschaft wird als Kaskadierbarkeit der HF-Chipmodule bezeichnet. Eine Kaskade von HF-Chipmodulen wird auch als Antennenarray bezeichnet,

Das erfindungsgemäße HF-Chipmodul weist ein streifenförmiges flächiges Substrat auf, auf dem mindestens ein HF-Chip angebracht ist. Die Leiterbahnen werden dabei zu den Längsseiten des Substrates von den Anschlüssen der zentral auf dem Substrat angeordneten HF-Chips zu Anschlussbereichen an den Schmalseiten des Substrates geführt. Dort münden die Leiterbahnen in Kontaktflächen, die mit der Leiterplatteneinrichtung der HF-Baugruppe leitend verbunden werden können. Die Breite der Schmalseiten des Substrates stimmen dabei vorzugsweise im Wesentlichen mit der Breite der HF-Chips überein.

Für die erfindungsgemäße Kaskadierbarkeit der HF-Chipmodule werden spezielle Ausführungsformen des HF-Chips verwendet. Durch die erfindungsgemäße Kaskadierung der HF-Chipmodule weisen die Mitten benachbarter Antenneneinrichtungen im Wesentlichen gleiche HF-Phasenabstände auf. Durch die Abstände der Mitten der Antenneneinrichtungen von einem ungeradzahligem Vielfachen es Viertels der effektiven Wellenlänge, die sich aus der HF-Frequenz der HF-Chips bestimmt, wird eine minimale gegenseitige Beeinflussung der Antenneneinrichtungen erzielt. Durch die erfindungsgemäße Kaskadierung mehrerer HF-Chipmodule zu Antennenarrays können mit bekannten Verfahren Abstände und Winkel von Objekten für verschiedene Anwendungsgebiete bestimmt werden.

Vorzugsweise ist ein HF-Chipmodul aufgebaut aus einem HF-Chip, der mittels Flip-Chip-Verfahren auf eine streifenförmige Folie aufgebracht ist. Die Folie stellt dabei das Substrat dar. Auf der Folie sind Leiterbahnen nach konventioneller Leiterplattenbauweise realisiert. Diese Leiterbahnen führen zur Längsseite der Folie und versetzt vom HF-Chip zu Anschlussbereichen, die mit durchkontaktierten Löchern realisiert sind, die, mit Produktionsanlagen nach dem Stand der Technik, auf einer Leiterplatteneinrichtung durch Pressklemmung oder Lötung leitend verbunden werden können. Weiterhin kann die Rückseite der Folie Resonatorelemente aufweisen, die über den entsprechenden Antenneneinrichtungen der HF-Chips angeordnet sind.

Auch können die Antenneneinrichtungen auf der Rückseite der Folie angebracht sein. In einem weiteren Beispiel weisen die Antenneneinrichtungen der HF-Chipmodule verschiedene geometrische Ausrichtungen, bevorzug 45°, relativ zur Schmalseite des Substrates aus. Zweckmäßig ist die Existenz einer Positionierungseinrichtung mit der die HF-Chipmodule auf den HF-Baugruppen präzise positioniert werden können. Insbesondere wird in mehreren Ausführungsbeispielen die Positionierungseinrichtung über zwei Passungslöcher in den Substraten der HF-Chipmodule und entsprechende Passstifte auf den Leiterplatteneinrichtungen realisiert.

Die Leiterplatteneinrichtung der erfindungsgemäßen HF-Baugruppen gemäß Anspruch 11 ist vorzugsweise mit einem länglichen Durchbruch versehen, sodass die Rückseiten der HF-Chips der HF-Chipmodule mit Wärme leitenden Klebstoff auf den Träger befestigt werden können. In einem weiteren Anwendungsbeispiel sind keine Passungslöcher auf der Folie vorgesehen, die Positionierungseinrichtung wird dabei durch die Vertiefung im Träger, in die die HF-Chips mit Wärme leitenden Kleber eingeklebt werden, als Positionierungseinrichtung ausgeführt. In diesen Anwendungsbeispielen bietet sich die Verwendung der Folie als Substrat dadurch an, dass zur Produktion hoher Stückzahlen diese auf einem langen Folienstreifen hergestellt werden können. Zur Materialersparnis wird dazu gegebenenfalls die äußere Reihe durchkontaktierten Löcher der Anschlusseinrichtung auf der Folie halb ausgeführt, bzw. die halbiert.

### ZEICHNUNGEN

In den Figuren zeigen:
- FIG. 1: eine schematische Ansicht der Vorderseite des HF-Chips (FIG. 1a) sowie Vorderseite (FIG. 1b) und Rückseite (FIG. 1c) des Substrates nach einem erstem Ausführungsbeispiel;
- FIG. 2: eine schematische Ansicht der Vorderseite des HF-Chips (FIG. 2a) sowie Vorderseite (FIG. 2b) und Rückseite (FIG. 2c) des Substrates nach einem zweitem Ausführungsbeispiel;
- FIG. 3: eine schematische Ansicht des ersten Ausführungsbeispiels mit dargestellter Vorderseite des Substrates und montiertem HF-Chip (FIG. 3a) sowie eine schematische Schnittansicht entlang der Linie Ia (FIG. 3b);
- FIG. 4: eine schematische Ansicht des zweiten Ausführungsbeispiels mit dargestellter Vorderseite des Substrates und montiertem HF-Chip (FIG. 4a) sowie eine schematische Schnittansicht entlang der Linie Ib (FIG. 4b);
- FIG. 5: eine schematische Ansicht einer Variante des ersten Ausführungsbeispiels mit dargestellter Vorderseite des Substrates und zwei montierten HF-Chips (FIG. 5a) sowie eine schematische Schnittansicht entlang der Linie IIa (FIG. 5b);
- FIG. 6: eine schematische Ansicht einer Variante des zweiten Ausführungsbeispiels mit dargestellter Vorderseite des Substrates und zwei montierten HF-Chips (FIG. 6a) sowie eine schematische Schnittansicht entlang der Linie IIb (FIG. 6b);
- FIG. 7: eine schematische Ansicht eines Ausführungsbeispiels einer HF-Baugruppe mit dargestelltem Träger der Leiterplatteneinrichtung sowie acht montierten HF-Chipmodulen nach erstem Ausführungsbeispiel (FIG. 7a), eine schematische Schnittansicht entlang der Linie IIIx (FIG. 7b) und eine schematische Schnittansicht entlang der Linie IIIy (FIG. 7c);
- FIG. 8: eine schematische Ansicht eines Ausführungsbeispiels einer HF-Baugruppe, wobei die Vertiefung des Trägers die Funktion der Positionierungseinrichtung hat (a), eine schematische Schnittansicht entlang der Linie IVx (FIG. 8b) und eine schematische Schnittansicht entlang der Linie IVy (FIG. 8c); und
- FIG. 9: eine schematische Ansicht zur Herstellung von HF-Chipmodulen.

### BESCHREIBUNG DER AUSFÜHRUNGSBEISPIELE

Gleiche oder funktionsgleiche Bauteile sind in den Figuren mit gleichen Bezugszeichen versehen.

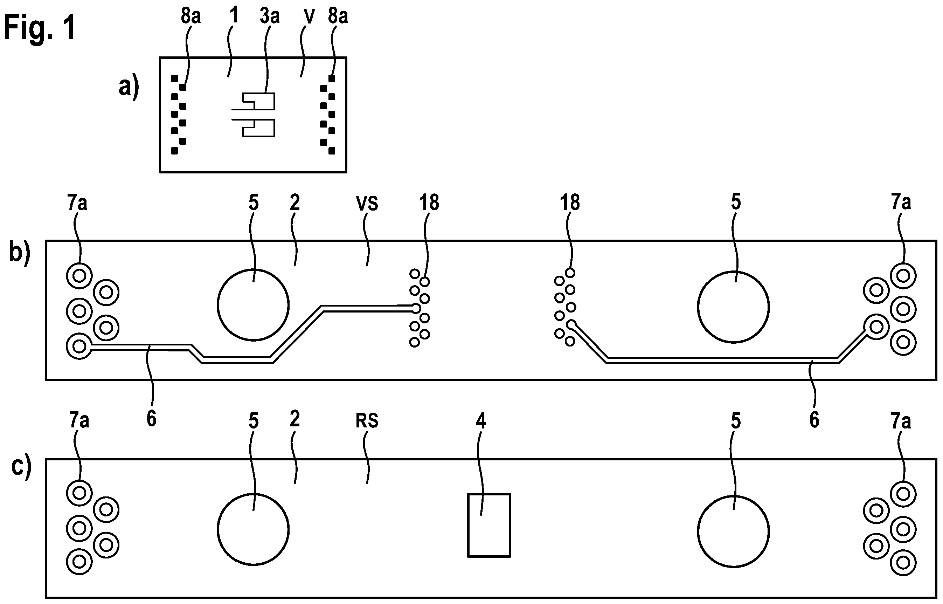

FIG. 1 ist die schematische Ansicht der Vorderseite V des HF-Chips (FIG. 1a) sowie der Vorderseite VS (FIG. 1b) und der Rückseite RS (FIG. 1c) des Substrates 2 nach einem erstem Ausführungsbeispiel.

Der HF-Chip 1 ist ein an sich bekannter Radar-HF-Chip zur Verwendung bei einem PKW-Abstandssensor. Zentral auf dem HF-Chip 1 angeordnet ist eine Antenneneinrichtung 3a. In weiteren Ausführungsbeispielen können mehrere Antenneneinrichtungen 3a zentral auf der Vorderseite V des HF-Chips 1 angeordnet sein. An den beiden Schmalseiten der Vorderseite V des HF-Chips 1 befinden sich jeweils in zwei Reihen Kontaktflächen 8a, mit denen der HF-Chip 1, nach der Montage auf der Vorderseite VS des Substrates 2 mit den Kontakten 18 des Substrates leitend verbunden ist. Die Montage erfolgt in diesem Ausführungsbeispiel durch Flip-Chip-Technik. In weiteren Ausführungsbeispielen können nur eine oder noch mehr Reihen von Kontaktflächen 8a vorgesehen sein.

FIG. 1b ist die schematische Ansicht der Vorderseite VS des streifenförmigen, flächigen Substrates 2,
welches bei diesem Beispiel eine dielektrische Folie 2 ist. Auf die Folie aufgedruckt sind im Wesentlichen parallel zur Längsseite des Substrates 2 verlaufenden Leiterbahnen 6, die die Kontakte 18 mit Anschlussbereichen 7a elektrisch leitend verbinden.

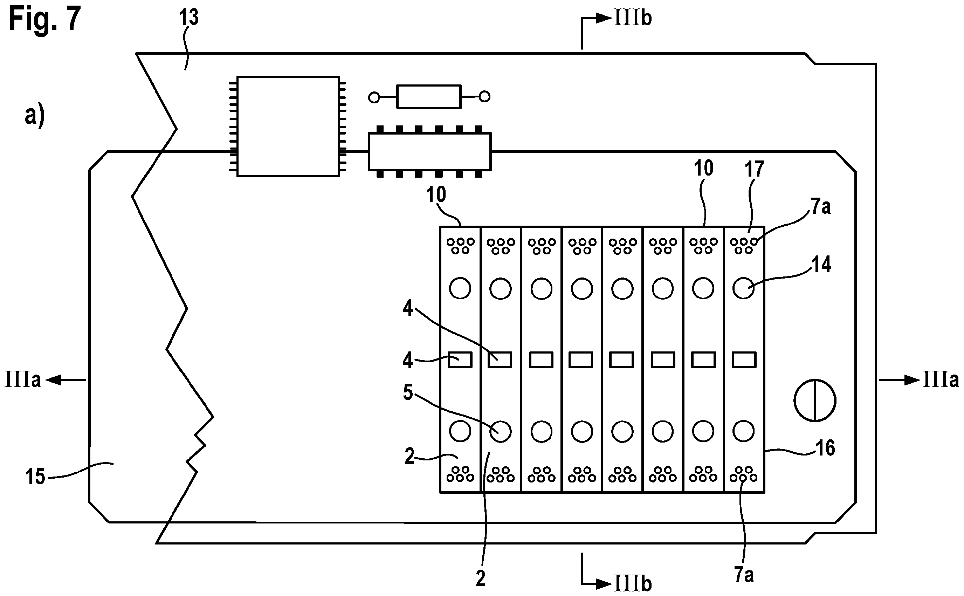

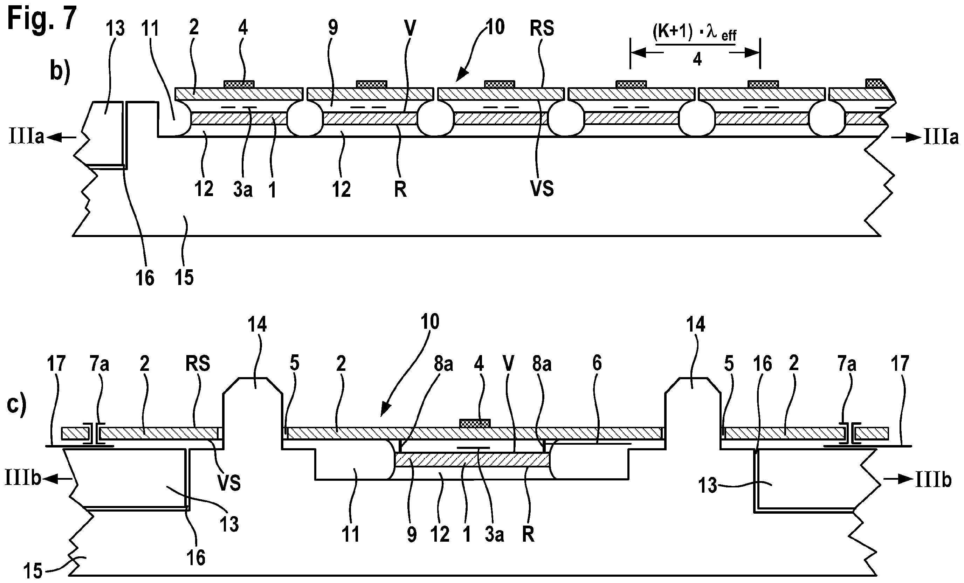

Die Anschlussbereiche 7a stellen die elektrischen Verbindungen eines HF-Chipmoduls 10 mit der Leiterplatteneinrichtung 13 einer HF-Baugruppe her (siehe FIG. 7). In diesem Ausführungsbeispiel sind die Anschlussbereiche 7a durch zwei Reihen von durchkontaktierten Löchern realisiert. In weiteren Ausführungsbeispielen sind die Anschlussbereiche 7a durch eine oder mehrere Reihen von vorderseitigen Kontaktflächen realisiert. Das Substrat 2 ist, bis auf die Leiterbahnen 6, im Wesentlichen spiegelsymmetrisch zur mittigen Orthogonalen der Längsseiten des Substrates 2 aufgebaut. Zentral angeordnet befinden sich einander gegenüberliegend zwei Reihen Kontaktflächen 18, die mit den zur Längsseite des Substrates 2 verlaufenden elektrischen Leiterbahnen 6 verbunden sind. Die Leiterbahnen 6 führen zur Schmalseite des Substrates 2, wo sie mit den Anschlussbereichen 7a leitend verbunden sind. In FIG. 1b sind zur Vereinfachung nur zwei mögliche Ausführungen der Leiterbahnen 6 dargestellt. Zwischen den Kontaktflächen 18 und den Anschlussbereichen 7a befinden sich in diesem Ausführungsbeispiel spiegelsymmetrisch zueinander angeordnet zwei Passungslöcher 5 zur Positionierung des Substrats auf entsprechenden Passungsstiften einer Leiterplatteneinrichtung (siehe FIG. 7).

FIG. 1c ist die schematische Ansicht der Rückseite RS des steifenförmigen, flächigen Substrates 2. Zentral angeordnet ist ein dielektrisches Resonatorelement 4, welches sich nach Montage des HF-Chips 1 oberhalb der Antenneneinrichtung 3a befindet. Zwischen dem Resonatorelement 4 und den Anschlussbereichen 7a erkennbar sind die beiden Passungslöcher 5 der Positionierungseinrichtung.

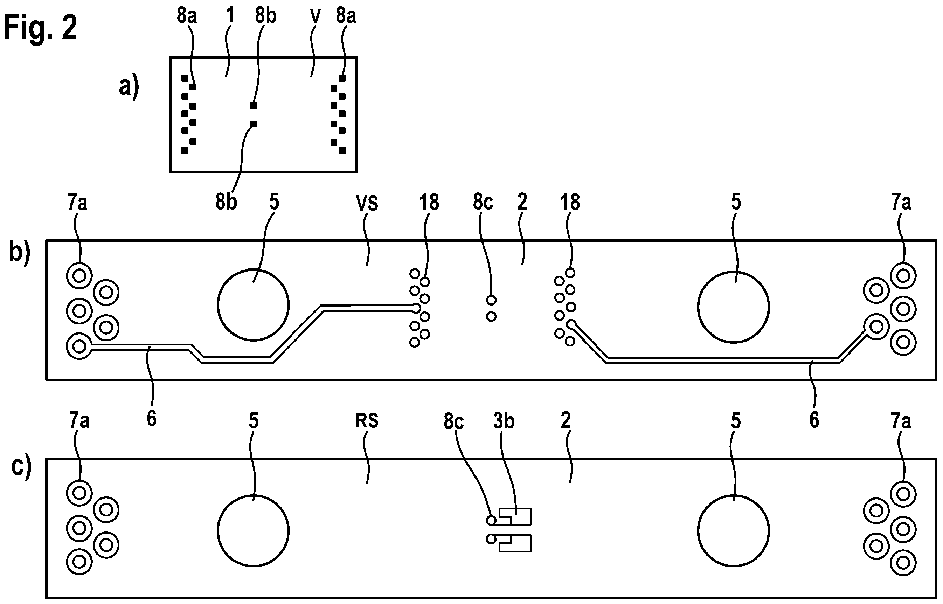

FIG. 2 ist eine schematische Ansicht der Vorderseite V des HF-Chips (FIG. 2a) sowie der Vorderseite VS (FIG. 2b) und der Rückseite RS (FIG. 2c) des Substrates 2 nach einem zweiten Ausführungsbeispiel. Zentral auf dem HF-Chip 1 angeordnet sind HF-Antennenanschlüsse 8b. Ansonsten ist der HF-Chip 1 identisch zum HF-Chip 1 gemäß FIG. 1a.

FIG. 2b ist die schematische Ansicht der Vorderseite VS des streifenförmigen, flächigen Substrates 2, welches bei dieser Ausführungsform zusätzlich Durchkontaktierungen 8c im mittleren Chipmontagebereich aufweist. Fig. 2c ist die schematische Ansicht der Rückseite RS des steifenförmigen, flächigen Substrates 2. Zentral angeordnet ist eine auf der Rückseite RS angebrachte Antenneneinrichtung 3b, die nach Montage des HF-Chips 1 über die Durchkontaktierungen 8c mit den HF-Antennenanschlüssen 8b des HF-Chips 1 leitend verbunden ist.

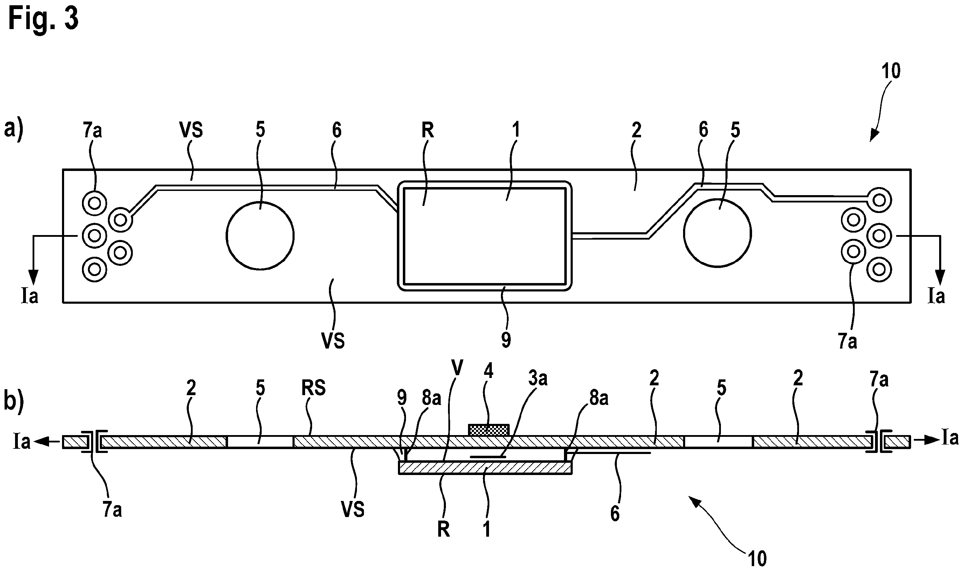

FIG. 3 ist eine schematische Ansicht des ersten Ausführungsbeispiels eines HF-Chipmoduls 10 mit dargestellter Vorderseite VS des streifenförmigen flächigen Substrates 2 und zentral darauf montiertem HF-Chip 1 (FIG. 3a) sowie eine schematische Schnittansicht entlang der Linie Ia (FIG. 3b).

In Fig. 3a ist die Vorderseite VS des Substrates 2 und entsprechend die Rückseite R des HF-Chips 1 dargestellt. Zwischen HF-Chip 1 und Substrat 2 befindet sich ein Underfill 9, der seitlich unter dem HF-Chip 1 hevorragt. Der HF-Chip 1 ist mit den Leiterbahnen 6 leitend verbunden, indem die Kontaktflächen 8a mit den Kontaktflächen 18 in Flip-Chip-Technik verlötet sind.

Fig. 3b ist eine schematische Schnittansicht entlang der Linie Ia aus Fig. 3a. Dabei weist die Rückseite RS des Substrates 2 nach oben und die Rückseite R des montierten HF-Chips 1 nach unten. Entsprechend weist die Vorderseite V des HF-Chips 1 zur Vorderseite VS des Substrates 2. Auf der Vorderseite V des HF-Chips 1 ist zentral die Antenneneinrichtung 3a unterhalb des Resonatorbereichs 4 angebracht. In den Außenbereichen des HF-Chips 1 befinden sich die Kontaktflächen 8a, die mit den Leiterbahnen 6 auf dem Substrat 2 elektrisch verbunden sind. Im Zwischenraum zwischen HF-Chip 1 und Substrat 2 befindet sich der Underfill 9.

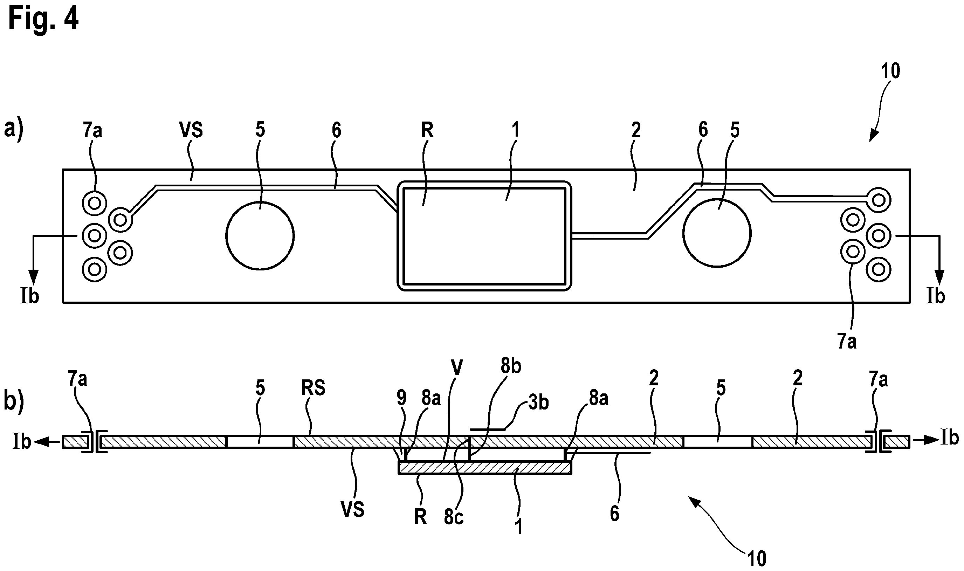

FIG. 4 ist eine schematische Ansicht des zweiten Ausführungsbeispiels des HF-Chipmoduls 10 mit dargestellter Vorderseite VS des streifenförmigen flächigen Substrates 2 und zentral darauf montiertem HF-Chip 1 (FIG. 4a) sowie eine schematische Schnittansicht entlang der Linie Ib (FIG. 4b).

Deutlich erkennbar in FIG. 4b ist die Verbindung der Antennenanschlüsse 8b über die Durchkontaktierungen 8c mit den Antenneneinrichtungen 3b, die bei diesem Beispiel auf der Folie 2 angebracht sind.

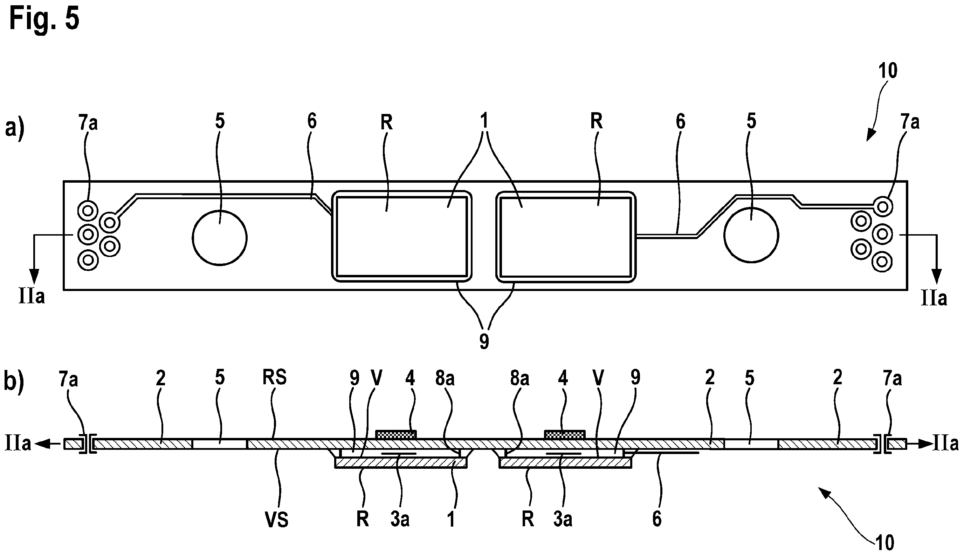

FIG. 5 ist eine schematische Ansicht einer Variante des ersten Ausführungsbeispiels mit dargestellter Vorderseite VS des Substrates und zwei montierten HF-Chips 1 (FIG. 5a) sowie eine schematische Schnittansicht entlang der Linie IIa (FIG. 5b).

In FIG. 5a, b sind die beiden HF-Chips 1 nebeneinander im Wesentlichen spiegelsymmetrisch und parallel zur Längsseite des streifenförmigen, flächigen Substrates 2 montiert. Beide HF-Chips 1 sind über zur Längsseite des Substrates 2 verlaufende Leiterbahnen 6 zu den nächstgelegenen Anschlussbereichen 7a am schmalen Ende des Substrates 2 verbunden. Jeweils zwischen einem HF-Chip 1 und den nächstgelegenen Anschlussbereichen 7a befindet sich das Passungsloch 5 der Positionierungseinrichtung. Bei dieser Variante sind vorzugsweise nur die Kontaktflächen 8a aktiviert, die zu den Schmalenden des Substrats 2 weisen. Kontakte mit gleichem Potential, z. B. Masse, können zwischen beiden HF-Chips verbunden werden mit Leitungen 20.

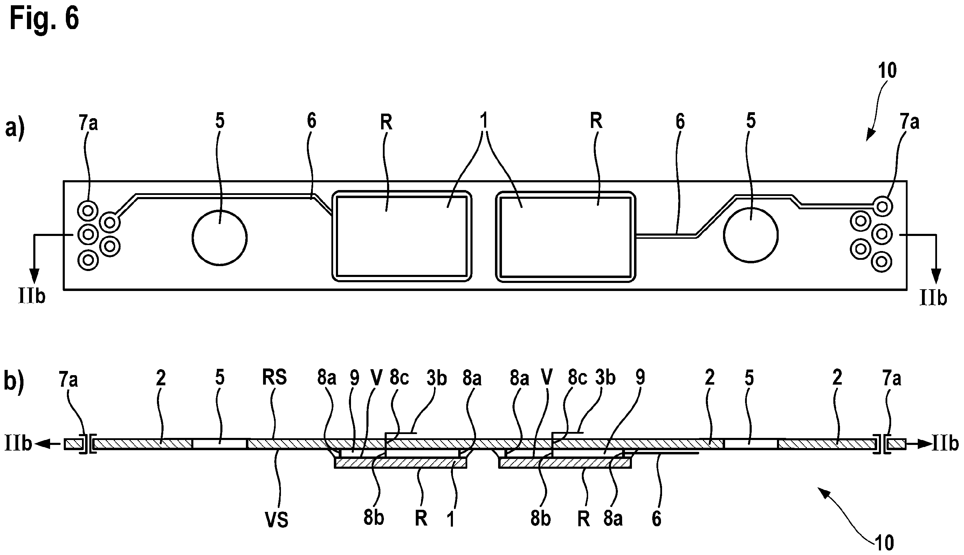

FIG. 6 ist die schematische Ansicht einer Variante des zweiten Ausführungsbeispiels mit dargestellter Vorderseite VS des Substrates und zwei montierten HF-Chips 1 (FIG. 6a) sowie eine schematische Schnittansicht entlang der Linie IIb (FIG. 6b). Diese Variante basiert auf dem Ausführungsbeispiel nach FIG. 3, welches die Antenneneinrichtungen auf der Folie 2 vorgesehen hat.

FIG. 7 ist eine schematische Ansicht eines Ausführungsbeispiels einer HF-Baugruppe mit dargestelltem Träger 15, einer Leiterplatteneinrichtung 13 sowie acht montierten HF-Chipmodulen (10) nach dem erstem Ausführungsbeispiel (FIG.7a), eine schematische Schnittansicht entlang der Linie III, (FIG. 7b) und eine schematische Schnittansicht entlang der Linie III, (FIG. 7c). In der Leiterplatteneinrichtung 13 befindet sich ein länglicher Durchbruch 16. Auf dem Durchbruch 16 sind die acht HF-Chipmodule 10 derart parallel nebeneinander angeordnet, dass die Passstifte 14 des Trägers 15 die HF-Chipmodule 10 über die Passungslöcher 5 der Positionierungseinrichtung ausrichten.

In FIG. 7b ist eine schematische Schnittansicht entlang der Linie III aus Fig. 7a dargestellt. Die Leiterplatteneinrichtung 13 befindet sich dabei auf dem Träger 15. Im Durchbruchbereich 16 befinden sich die Chipmodule 10. Jedes HF-Chipmodul 10 ist über die Rückseite R des HF-Chips 1 mit dem Träger 15 durch einen Wärmeleitklebestoff 12 verklebt. Auf den Vorderseiten V der HF-Chips 1 befinden sich die Antenneneinrichtungen 3a. Oberhalb der Antenneneinrichtungen 3a sind an der Rückseite der Substrate 2 die Resonatorelemente 4 angeordnet. Die Mitten der Antenneneinrichtungen 3a haben voneinander einen Abstand gleich dem nichtgeradzahligen Vielfachen des Viertels der effektiven Wellenlänge, die sich aus der HF-Frequenz der HF-Chips 1 bestimmt.

FIG. 7c ist eine schematische Schnittansicht entlang der Linie III. Die Leiterplatteneinrichtung 13 ist auf dem Träger 15 angebracht. An der Innenseite des Durchbruchs 16 befinden sich die Passstifte 14 des Trägers 15. Zwischen den Passstiften 14 des Trägers 15 befindet sich eine Vertiefung 11, in der die HF-Chips 1 der Chipmodule 10 mit einem wärmeleitfähigen Klebstoff 12 auf dem Träger 15 verklebt sind. Die Substrate 2 der Chipmodule 10 sind dabei über die Passungslöcher 5 und die Passstife 14 der Positionierungseinrichtung 5 orientiert. Die Anschlussbereiche 7a sind dabei mit den Kontaktflächen 17 der Leiterplatteneinrichtung 13 leitend verbunden, z. B. durch Löten.

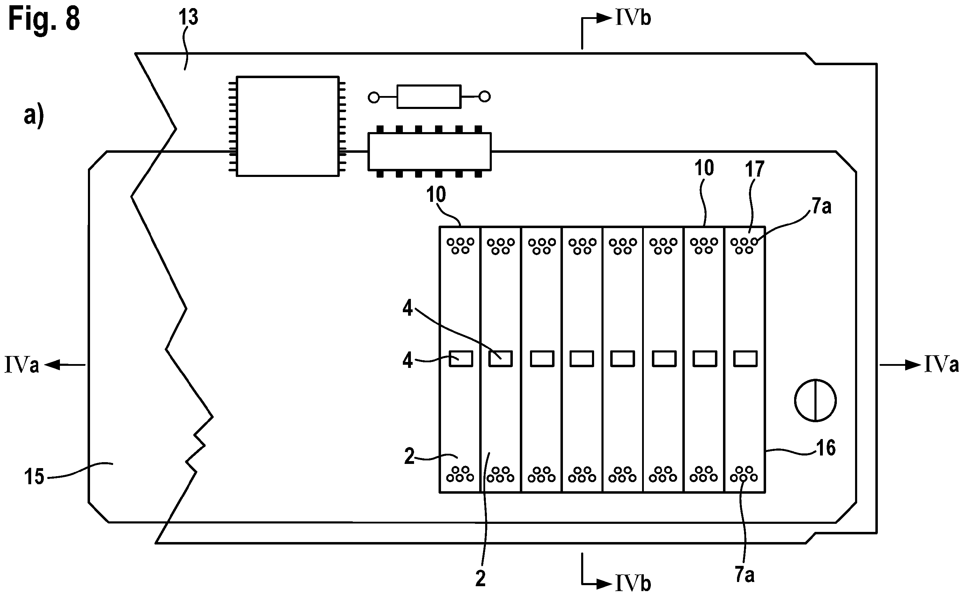

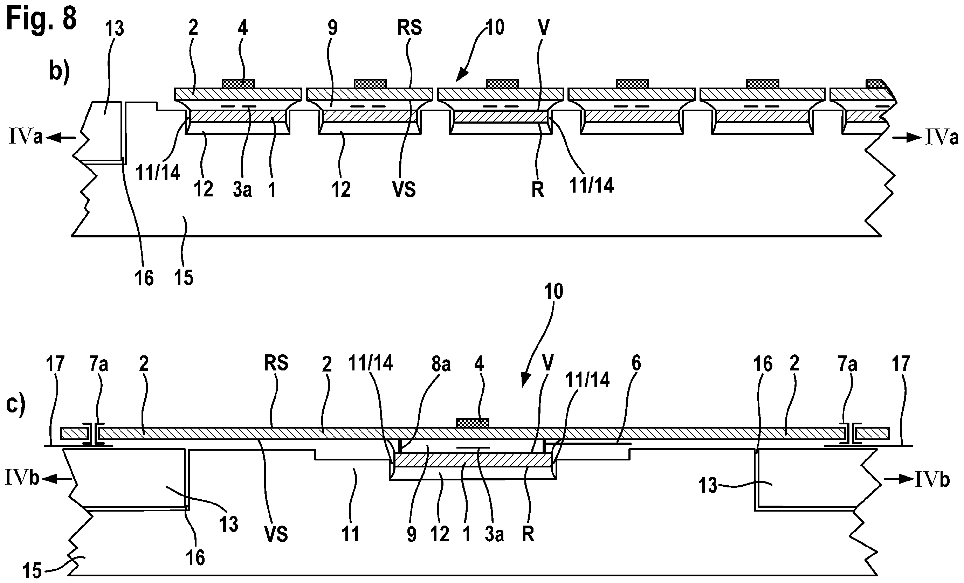

FIG. 8 ist eine schematische Ansicht eines Ausführungsbeispiels einer HF-Baugruppe mit dargestelltem Träger 15, wobei die Vertiefung 11 des Trägers 15 die Funktion der Positionierungseinrichtung hat, der Leiterplatteneinrichtung 13 sowie acht montierten HF-Chipmodulen (10) nach erstem Ausführungsbeispiel (FIG.8a), jedoch ohne Passungslöcher 5, eine schematische Schnittansicht entlang der Linie IVa (FIG. 8b) und eine schematische Schnittansicht entlang der Linie IVb (FIG. 8c).

Wie in FIG. 8a ersichtlich, befindet sich in der Leiterplatteneinrichtung 13 ein länglicher Durchbruch 16, in dem der Träger 15 mit der geeignet ausgeführten Vertiefung 11 ausgestattet ist, in die die HF-Chips 1 der HF-Chipmodule 10 bei der Montage auf die HF-Baugruppe positioniert werden. Die Funktion der Positionierungseinrichtung ist bei diesem Ausführungsbeispiel durch die Vertiefung 11 ausgeübt, die die HF-Chips annähernd formschlüssig aufnimmt.

Wie in FIG. 8b, 8c dargestellt, befindet sich die Leiterplatteneinrichtung 13 auf dem Träger 15. Im Durchbruchbereich 16 befinden sich die Chipmodule 10. Jedes HF-Chipmodul 10 ist über die Rückseite R des HF-Chips 1 mit der Vertiefung 11 des Träger 15 durch einen Wärmeleitklebestoff 12 verklebt. Auf den Vorderseiten V der HF-Chips 1 befinden sich die Antenneneinrichtungen 3a. Oberhalb der Antenneneinrichtungen 3a sind an der Rückseite der Substrate 2 die Resonatorelemente 4 angeordnet. Die Mitten der Antenneneinrichtungen 3a haben voneinander einen Abstand gleich dem nichtgeradzahligen Vielfachen des Viertels der effektiven Wellenlänge, die sich aus der HF-Frequenz der HF-Chips 1 bestimmt.

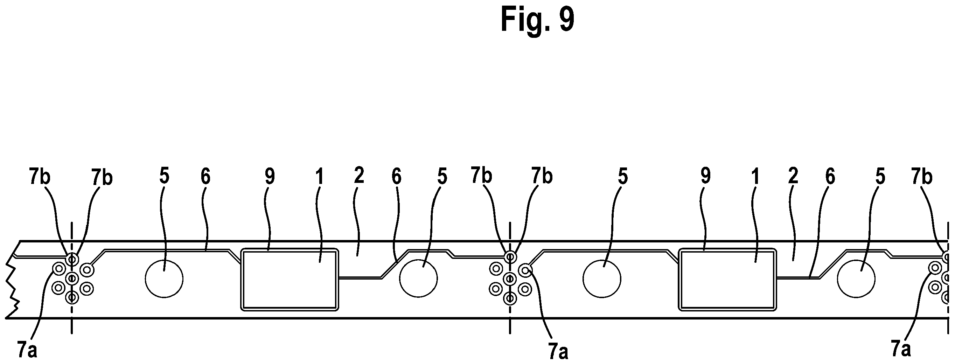

In FIG. 9 ist eine schematische Ansicht zur Herstellung von Folien 2 für HF-Chipmodule 10 nach einem der vorhergehenden Ausführungsbeispiele dargestellt. Bei der Herstellung werden mehrere Substrate auf einem gemeinsamen Folienstreifen ausgeführt und zu einem späteren Zeitpunkt im Herstellungsprozess durch einen Schnitt voneinander getrennt. Beim vorliegenden Beispiel werden beim Schnitt die äußersten Kontaktbereiche 7b zur Materialersparnis halbiert.

Eine Optimierung der Breite bzw. des Abstands der Substrate 2 wird zweckmäßigerweise unter Berücksichtigung der Kompaktheit und Interferenzfreiheit durchgeführt.

Um die HF-Chipmodule 10 so schmal wie möglich zu gestalten, wird die Folie 2 an die notwendige minimale Breite des HF-Chips 1 angepasst. Damit kann in einer Reihe nur eine bestimmte Anzahl von Anschlussbereichen 7a realisiert werden. Bei weiteren notwendigen Anschlussbereichen 7a werden diese dann in zusätzlichen Reihen angeordnet. Die Folie wird dann bei gleicher Breite entsprechend länger.

Die HF-Chipmodule 10 sind vorzugsweise zueinander so montiert, dass alle Mitten der einzelnen Antennenabstände (Pitchabstand) zueinander den gleichen elektrischen HF-Phasenabstand aufweisen. Ist auf einem Modul 10 nur eine Antenne 3a angeordnet, haben alle Antennen auch den gleichen mechanischen Abstand. Sind auf einem Modul 10 zwei Antennen angeordnet die beide zu einer gleichen Arrayreihe gehören, kann hier der mechanische Abstand zwischen Antennen auf dem Modul und der benachbarten Antenne des danebenliegenden Moduls differieren. Abhängig ist dies auch davon, ob über den Antennen auf der Folie noch weitere Antennenelemente, Z. B. Polyrods, angeordnet sind. Mit den gleichen Phasenabständen hat man Antennenarrays mit denen nach bekannten Verfahren der Abstand- und Winkel von Objekten bestimmt werden kann. Die Abstände können mit geeigneter anderer Auswertung auch so zueinander gewählt werden, dass ein Minimum gegenseitiger Beeinflussung erreicht wird, z. B. mit (k+1)**λ_{eff}/4 (mit k = 0, 2, 4, ...). λ_{eff}, gegeben durch die beteiligten dielektrischen Stoffe (u. A. Chip, Folie, Underfill, Luft), ist kleiner als in reiner Luft bei 79 GHz von λ_{Luft}/4 gleich 0.95 mm.

Die Modulbreite ergibt sich aus der Chipbreite plus der technologischen Notwendigkeiten wie Randüberstand der Underfills und allen Toleranzen (Chip-, Folienbreite, Montage). Um geringe Pitchabstände der Antennen zu erreichen wird der Chip möglichst schmal entworfen. Randbedingungen sind dabei zu beachten: Sinnvolles Längen-/Breitenverhältnis ist einzuhalten (∼ <2), Antennen auf dem Chip brauchen eine bestimmte Fläche und Abstände zu Schaltung und Chiprand. Gewisse Freiheitsgrade hat man bei der Anordnung der Schaltung auf dem Chip. Vorteilhaft ist, dass auch bei hoher Anzahl der Kontakte praktisch die Chip- und damit die Modulbreite beibehalten werden kann. Bei entsprechendem Bedarf können ohne Problem mehrere FC-Kontaktreihen jeweils an den beiden Seiten die den Antennenreihen abgewandt sind, realisiert werden. Allerdings wird dadurch der Chip etwas länger, je Reihe ca. 200 µm.

## Patentansprüche

1. HF-Chipmodul mit:
einem streifenförmigen, flächigen Substrat (2) mit einer vorderseitigen Oberfläche (VS) und einer rückseitigen Oberfläche (RS);
mindestens einem HF-Chip (1) mit einer Vorderseite (V) und einer Rückseite (R), der über seine Vorderseite (V) auf vorderseitige Oberfläche (V) des Substrates (2) angebracht ist;
wobei die Vorderseite (V) des HF-Chips (1) mindestens eine Antenneneinrichtung (3a) aufweist oder mindestens einen Antennenanschluss (8b) aufweist, der mit einer auf der rückseitigen Oberfläche (RS) des Substrates (2) vorgesehenen Antenneneinrichtung (3b) verbunden ist;
wobei die Vorderseite (V) des HF-Chips (1) Kontaktflächen (8a) aufweist, die mit auf der vorderseitigen Oberfläche (VS) des Substrates (2) vorgesehenen Leiterbahnen (6) verbunden sind;
wobei die Leiterbahnen (6) zu entsprechenden Anschlussbereichen (7a; 7b) verlaufen, welche vom HF-Chip (1) in Längsrichtung zur Schmalseite des Substrates (2) versetzt zumindest auf der vorderseitigen Oberfläche (VS) des Substrates (2) vorgesehen sind;
und welche zum Bilden elektrischer Verbindungen des HF-Chipmoduls eingerichtet sind; und
wobei die Anschlussbereiche (7a; 7b) durchkontaktierte Löcher sind.

2. HF-Chipmodul nach Anspruch 1, wobei die Breite des Substrates (2) im wesentlichen mit einer Breite des HF-Chips (1) übereinstimmt.

3. HF-Chipmodul nach einem der Ansprüche 1 oder 2, wobei das Substrat (2) eine dielektrische Folie ist.

4. HF-Chipmodul nach einem der Ansprüche 1 oder 2, wobei mehrere HF-Chips (1) auf dem Substrat (2) vorgesehen sind, deren benachbarte Antenneneinrichtungen (3a; 3b) einen Abstand von einem ungeradzahligen Vielfachen eines Viertels der effektiven Wellenlänge, die sich aus der HF-Frequenz der Antenneneinrichtungen (3a; 3b) bestimmt, aufweisen.

5. HF-Chipmodul nach Anspruch 4, wobei die Antenneneinrichtungen (3a; 3b) zueinander unterschiedliche geometrische Ausrichtungen aufweisen.

6. HF-Chipmodul nach einem der Ansprüche 1 bis 3, wobei an der rückseitigen Oberfläche (RS) des Substrates (2) ein Resonatorelement (4) oberhalb der Antenneneinrichtung (3a) vorgesehen ist.

7. HF-Chipmodul nach einem der Ansprüche 1 bis 6, wobei die Leiterbahnen (6) auf das Substrat (2) aufgedruckt sind.

8. HF-Chipmodul nach einem der Ansprüche 1 bis 7, wobei eine Positionierungseinrichtung (5) zum Ausrichten des Substrats (2) auf der Leiterplatteneinrichtung (13) vorgesehen ist.

9. HF-Chipmodul nach Anspruch 8, wobei die Positionierungseinrichtung (5) zwei Passungslöcher (5) im Substrat (2) aufweist.

10. HF-Chipmodul nach einem der Ansprüche 1 bis 9, wobei die äußeren Kontaktflächen (7b) an den Schmalenden des Substrats halbierte Anschlussbereiche (7b) sind.

11. HF-Baugruppe mit:
einer Leiterplatteneinrichtung (13); und
einer Mehrzahl von auf der Leiterplatteneinrichtung (13) montierten HF-Chipmodulen (10) nach einem der vorhergehenden Ansprüche;
wobei die Substrate (2) der HF-Chipmodule (10) im Wesentlichen parallel zu einander ausgerichtet sind; und wobei die Anschlussbereiche (7a; 7b) elektrische Verbindungen der HF-Chipmodule (10) mit der Leiterplatteneinrichtung (13) bilden.

12. HF-Baugruppe nach Anspruch 11, wobei die HF-Chipmodule (10) einen identischen Aufbau aufweisen.

13. HF-Baugruppe nach Anspruch 11 oder 12, wobei die Leiterplatteneinrichtung (13) einen länglichen Durchbruch (16) aufweist, unterhalb dessen ein Träger (15) vorgesehen ist, auf dem die Rückseite (R) der HF-Chips (1) der HF-Chipmodule (10) angebracht sind.

14. HF-Baugruppe nach Anspruch 13, wobei der Träger (15) aus einem metallischen Material besteht und die HF-Chips (1) mit Wärmeleitklebstoff (12) auf den Träger (15) geklebt sind.

15. HF-Baugruppe nach Anspruch 13 oder 14, wobei eine im Träger (15) vorgesehene Vertiefung (11) zum Ausrichten der HF-Chips (1) auf der Leiterplatteneinrichtung (13) dient.

16. HF-Baugruppe nach einem der Ansprüche 11 bis 15, wobei die Mitten der Antenneneinrichtungen (3a; 3b) benachbarter HF-Chipmodule (10) einen Abstand von einem ungeradzahligen Vielfachen eines Viertels der effektiven Wellenlänge, die sich aus der HF-Frequenz der Antenneneinrichtungen (3a; 3b) bestimmt, aufweisen.

17. HF-Baugruppe nach einem der Ansprüche 11 bis 16, wobei die Leiterplatteneinrichtung (13) und/oder der Träger (15) Passstifte (14) aufweisen, die mit Passungslöchern (5) in dem Substrat (2) zusammenwirken, um die HF-Chipmodule (10) auf der Leiterplatteneinrichtung (13) auszurichten.

18. Verfahren zur Herstellung einer HF-Baugruppe nach einem der Ansprüche 11 bis 17 mit den Schritten:
Fertigstellen der HF-Chipmodule (10);
Positionieren der HF-Chipmodule (10) auf der Leiterplatteneinrichtung (13);
Verbinden der HF-Chips (1) mit der Leiterplatteneinrichtung (13) oder einem damit verbundenen Träger (15);
elektrisches Verbinden der Anschlussbereiche (7a; 7b) mit auf der Leiterplatteneinrichtung (13) vorgesehenen Leiterbahnen (17).

## Claims

1. HF chip module comprising:
a strip-like, flat substrate (2) with a front surface (VS) and a rear surface (RS);
at least one HF chip (1) having a front side (V) and a rear side (R), which is attached via its front side (V) to the front surface (V) of the substrate (2);
wherein the front side (V) of the HF chip (1) has at least one antenna device (3a) or has at least one antenna connection (8b), which is connected to an antenna device (3b) provided on the rear surface (RS) of the substrate (2);
wherein the front side (V) of the HF chip (1) has contact pads (8a), which are connected to conductor tracks (6) provided on the front surface (VS) of the substrate (2);
wherein the conductor tracks (6) run to corresponding connecting regions (7a; 7b), which are provided at least on the front surface (VS) of the substrate (2), offset from the HF chip (1) in the longitudinal direction toward the narrow side of the substrate (2);
and which are configured to form the electrical connections of the HF chip module; and
wherein the connecting regions (7a; 7b) are plated-through holes.

2. HF chip module according to Claim 1, wherein the width of the substrate (2) substantially coincides with a width of the HF chip (1).

3. HF chip module according to either of Claims 1 and 2, wherein the substrate (2) is a dielectric film.

4. HF chip module according to either of Claims 1 and 2, wherein multiple HF chips (1) are provided on the substrate (2), the adjacent antenna devices (3a; 3b) of which have a spacing of an odd multiple of one quarter of the effective wavelength, which is determined from the HF frequency of the antenna devices (3a; 3b).

5. HF chip module according to Claim 4, wherein the antenna devices (3a; 3b) have different geometric alignments relative to one another.

6. HF chip module according to one of Claims 1 to 3, wherein a resonator element (4) is provided on the rear surface (RS) of the substrate (2), above the antenna device (3a).

7. HF chip module according to one of Claims 1 to 6, wherein the conductor tracks (6) are printed onto the substrate (2).

8. HF chip module according to one of Claims 1 to 7, wherein a positioning device (5) for aligning the substrate (2) on the conductor board device (13) is provided.

9. HF chip module according to Claim 8, wherein the positioning device (5) has two alignment holes (5) in the substrate (2).

10. HF chip module according to one of Claims 1 to 9, wherein the outer contact pads (7b) on the narrow ends of the substrate are halved contact regions (7b).

11. HF assembly comprising:
a circuit board device (13); and
a plurality of HF chip modules (10) according to one of the preceding claims mounted on the circuit board device (13);
wherein the substrates (2) of the HF chip modules (10) are aligned substantially parallel to one another; and wherein the connecting regions (7a; 7b) form electrical connections of the HF chip modules (10) to the circuit board device (13).

12. HF assembly according to Claim 11, wherein the HF chip modules (10) have an identical structure.

13. HF assembly according to Claim 11 or 12, wherein the circuit board device (13) has an elongated aperture (16), underneath which a carrier (15) is provided, to which the rear side (R) of the HF chips (1) of the HF chip modules (10) are attached.

14. HF assembly according to Claim 13, wherein the carrier (15) consists of a metallic material and the HF chips (1) are stuck to the carrier (15) with heat-conducting adhesive (12).

15. HF assembly according to Claim 13 or 14, wherein a depression (11) provided in the carrier (15) serves to align the HF chips (1) on the circuit board device (13).

16. HF assembly according to one of Claims 11 to 15, wherein the centres of the antenna devices (3a; 3b) of adjacent HF chip modules (10) have a spacing of an odd multiple of one quarter of the effective wavelength, which is determined from the HF frequency of the antenna devices (3a; 3b).

17. HF assembly according to one of Claims 11 to 16, wherein the circuit board device (13) and/or the carrier (15) have alignment pins (14), which interact with alignment holes (5) in the substrate (2) in order to align the HF chip modules (10) on the circuit board device (13).

18. Method for producing an HF assembly according to one of Claims 11 to 17, comprising the steps:
completing the HF chip modules (10);
positioning the HF chip modules (10) on the circuit board device (13);
connecting the HF chips (1) to the circuit board device (13) or to a carrier (15) connected to the latter;
connecting the connecting regions (7a; 7b) electrically to conductor tracks (17) provided on the circuit board device (13).

## Revendications

1. Module de puce HF avec :
un substrat (2) en feuille et en forme de bande qui présente une surface (VS) se trouvant sur le côté avant et une surface (RS) se trouvant sur le côté arrière ;
au moins une puce HF (1), laquelle comprend une face avant (V) et une face arrière (R) et laquelle est mise en place par sa face avant (V) sur la surface (V) du substrat (2) qui se trouve sur le côté avant ;
dans lequel la face avant (V) de la puce HF (1) présente au moins un mécanisme à antenne (3a) ou présente au moins un branchement pour antenne (8b), lequel est relié à un mécanisme à antenne (3b) prévu sur la surface (RS) du substrat (2) qui se trouve sur le côté arrière ;
dans lequel la face avant (V) de la puce HF (1) présente des surfaces de contact (8a), lesquelles sont reliées à des pistes conductrices (6) prévues sur la surface (VS) du substrat (2) qui se trouve sur le côté avant ;
dans lequel les pistes conductrices (6) s'étendent jusqu'à des zones de connexion (7a ; 7b) correspondantes, lesquelles sont prévues tout au moins sur la surface (VS) du substrat (2) qui se trouve sur le côté avant, et lesquelles sont décalées de la puce HF (1) dans le sens de la longueur par rapport à la face étroite du substrat (2), et lesquelles sont mises en place en vue de l'établissement de connexions électriques du module de puce HF ; et
dans lequel les zones de connexion (7a ; 7b) sont des trous de traversée métallisés.

2. Module de puce HF selon la revendication 1, dans lequel la largeur du substrat (2) coïncide, pour l'essentiel, avec une largeur de la puce HF (1).

3. Module de puce HF selon l'une des revendications 1 ou 2, dans lequel le substrat (2) est un film diélectrique.

4. Module de puce HF selon l'une des revendications 1 ou 2, dans lequel plusieurs puces HF (1) sont prévues sur le substrat (2), dont les mécanismes à antenne (3a ; 3b) voisins présentent un écartement correspondant à un multiple d'un nombre impair d'un quart de la longueur d'onde effective, laquelle est déterminée à partir de la fréquence HF des mécanismes à antenne (3a ; 3b).

5. Module de puce HF selon la revendication 4, dans lequel les mécanismes à antenne (3a ; 3b) présentent des alignements géométriques différents les uns par rapport aux autres.

6. Module de puce HF selon l'une des revendications 1 à 3, dans lequel un élément résonateur (4) est prévu au-dessus du mécanisme à antenne (3a), au niveau de la surface (RS) du substrat (2) qui se trouve sur le côté arrière.

7. Module de puce HF selon l'une des revendications 1 à 6, dans lequel les pistes conductrices (6) sont imprimées sur le substrat (2).

8. Module de puce HF selon l'une des revendications 1 à 7, dans lequel une mise en place du positionnement (5) est prévue en vue de l'alignement du substrat (2) sur le système de carte de circuit imprimé (13).

9. Module de puce HF selon la revendication 8, dans lequel la mise en place du positionnement (5) présente deux trous d'ajustement (5) dans le substrat (2).

10. Module de puce HF selon l'une des revendications 1 à 9, dans lequel les surfaces de contact (7b) externes sont des zones de connexion (7b) réduites de moitié au niveau des extrémités étroites du substrat.

11. Unité de montage HF avec :
un système de carte de circuit imprimé (13) ; et
une majorité de modules de puce HF (10) montés sur le système de carte de circuit imprimé (13) selon l'une des revendications précédentes ;
dans laquelle les substrats (2) des modules de puce HF (10) sont alignés pour l'essentiel de manière parallèle les uns par rapport aux autres ; et
dans laquelle les zones de connexion (7a ; 7b) forment des connexions électriques des modules de puce HF (10) avec le système de carte de circuit imprimé (13).

12. Unité de montage HF selon la revendication 11, dans laquelle les modules de puce HF (10) présentent une structure identique.

13. Unité de montage HF selon la revendication 11 ou 12, dans laquelle le système de carte de circuit imprimé (13) présente une percée (16) longitudinale, au-dessous de laquelle est prévu un support (15), sur lequel est mise en place la face arrière (R) des puces HF (1) des modules de puce HF (10).

14. Unité de montage HF selon la revendication 13, dans laquelle le support (15) est constitué d'un matériau métallique et les puces HF (1) sont encollées sur le support (15) au moyen d'un agent adhésif thermoconducteur (12).

15. Unité de montage HF selon la revendication 13 ou 14, dans laquelle un renfoncement (11) prévu dans le support (15) sert à l'alignement des puces HF (1) sur le système de carte de circuit imprimé (13).

16. Unité de montage HF selon l'une des revendications 11 à 15, dans laquelle les centres des mécanismes à antenne (3a ; 3b) des modules de puce HF (10) voisins présentent un écartement correspondant à un nombre impair multiple d'un quart de la longueur d'onde effective, laquelle est déterminée à partir de la fréquence HF des mécanismes à antenne (3a ; 3b).

17. Unité de montage HF selon l'une des revendications 11 à 16, dans laquelle le système de carte de circuit imprimé (13) et/ou le support (15) présentent des goupilles de positionnement (14) qui interagissent avec des trous d'ajustement (5) dans le substrat (2), en vue d'aligner les modules de puce HF (10) sur le système de carte de circuit imprimé (13).

18. Procédé destiné à la fabrication d'une unité de montage HF selon l'une des revendications 11 à 17, comprenant les phases suivantes :
la réalisation des modules de puce HF (10) ;
le positionnement des modules de puce HF (10) sur le système de carte de circuit imprimé (13) ;
la jonction des puces HF (1) avec le système de carte de circuit imprimé (13) ou avec un support (15) qui lui est relié ;
la liaison électrique des zones de connexion (7a ; 7b) avec des pistes conductrices (17) prévues sur le système de carte de circuit imprimé (13).
